# DEMANDE DE BREVET EUROPEEN

(11) **EP 4 006 566 A1**
(43) Date de publication de la demande: **01.06.2022**
(21) Numéro de dépôt: 21210522.5
(22) Date de dépôt: 25.11.2021
(51) Int. Cl.: G01R 33/00, G01R 15/20, G01R 33/02, H01L 23/495, G01R 33/07, G01R 33/09

(54) **DISPOSITIF ÉLECTRIQUE DE MESURE DE CHAMP MAGNÉTIQUE POUR RÉALISER UNE MESURE DE COURANT**

(30) Priorité: 26.11.2020 FR 2012194
(71) Demandeur: Valeo Siemens eAutomotive France SAS, 95800 Cergy (FR)
(72) Inventeur: LEGENDRE, Alexandre, 95800 Cergy (FR); POUILLY, Aurelien, 95800 Cergy (FR)
(74) Mandataire: Novembre, Christophe Adelphe

(57) **Abrégé**

L'invention concerne un dispositif électrique (1) comprenant un support (11) comprenant un organe de maintien (111), et un circuit électrique (12) logé au moins partiellement dans le support (11) et comprenant un réseau de pistes électriques (122) et une portion réceptrice (121) adaptée pour recevoir un capteur de champ magnétique. Le circuit électrique (12) est configuré pour assurer une liaison électrique entre le capteur de champ magnétique et une carte électronique externe au dispositif électrique (1). L'organe de maintien (111) comprend au moins une portion d'appui (112) formant butée pour assurer une liaison mécanique entre le support (11) et la carte électronique, de sorte à positionner le capteur de champ magnétique dans un volume libre aménagé dans un conducteur électrique, afin de permettre au capteur de champ magnétique d'effectuer des mesures de champ magnétique induit par un courant circulant dans le conducteur électrique.

## Description

### DOMAINE TECHNIQUE

La présente invention se rapporte au domaine du contrôle de systèmes électriques, notamment pour véhicule, en particulier pour véhicules électriques ou hybrides. Plus précisément, la présente invention vise un dispositif électrique pour la mesure de courant à des fins de contrôle d'un système électrique.

Comme cela est connu, un véhicule automobile électrique ou hybride comprend un système de motorisation électrique alimenté par une batterie d'alimentation haute tension via un réseau électrique embarqué haute tension. La batterie d'alimentation haute tension assure une fonction d'alimentation en énergie du système de motorisation électrique permettant la propulsion du véhicule. Plus précisément, afin de commander la machine électrique entrainant les roues du véhicule, il est connu d'utiliser un onduleur permettant de convertir le courant continu fourni par la batterie d'alimentation haute tension en un ou plusieurs courants de commande alternatifs, par exemple sinusoïdaux.

A cette fin, l'onduleur comprend des composants électriques par lesquels passe l'énergie alimentant la machine électrique, ainsi qu'une unité électronique de contrôle comprenant des composants électroniques permettant de contrôler les composants électriques de l'onduleur. Les composants électriques de l'onduleur peuvent être agencés dans un module électronique de puissance.

L'onduleur comporte aussi des conducteurs électriques, notamment au nombre de trois en triphasé, connectés aux phases de la machine électrique, ou d'une manière générale à un nombre multiple de trois si l'onduleur alimente plusieurs machines électriques triphasées. Chaque conducteur électrique du système électrique considéré, également désigné « leadframe » selon le terme en langue anglaise connu de l'homme de l'art, est relié à un connecteur de phase de la machine électrique.

Comme cela est connu, afin de contrôler le fonctionnement d'un système électrique contrôlant une machine électrique, tel qu'un onduleur contrôlant la machine électrique, la connaissance du courant circulant dans chaque phase de la machine électrique est nécessaire afin de réaliser une commande adaptée de l'onduleur alimentant ladite machine électrique en énergie électrique.

Dans ce but, il est connu de réaliser une mesure de courant au niveau d'un conducteur électrique du système électrique considéré. En général, dans le contexte d'un onduleur triphasé, il est suffisant de réaliser les mesures de courant au niveau de deux des trois conducteurs électriques, le courant circulant dans le troisième conducteur pouvant être déterminé à partir des courants circulant dans les deux autres conducteurs. Cette mesure de courant passe généralement par une mesure de champ magnétique. Un capteur mesurant le champ magnétique est par conséquent disposé de manière à mesurer le champ magnétique induit par le courant au niveau d'un conducteur électrique correspondant du système électrique. La valeur de chaque champ magnétique sert alors à déterminer l'intensité du courant.

Typiquement, le capteur mesurant le champ magnétique est monté sur une carte électronique qui va délivrer la valeur du courant sur la base de la mesure effectuée par le capteur mesurant le champ magnétique. Le capteur est généralement à distance de la carte électronique pour être au plus proche du conducteur électrique, et est relié à celle-ci par des broches. Cependant, cette connexion électrique entre le capteur et la carte électronique peut être fragilisée, par exemple du fait de contraintes mécaniques exercées sur les broches et/ou au niveau de la jonction entre les broches et le capteur.

De plus, certains capteurs de champ magnétique connus peuvent utiliser dans l'assemblage un concentrateur de champ magnétique, notamment en forme de C ou de U, avec un entrefer. Le concentrateur de champ magnétique permet en particulier d'améliorer la précision de mesure du champ magnétique, mais est encombrant.

Or, aujourd'hui, en particulier dans le domaine de l'automobile, les contraintes liées à l'encombrement sont de plus en plus fortes. Ainsi, il existe un besoin pour un capteur de champ magnétique permettant la détermination d'un courant de sortie d'un onduleur qui permette une diminution de l'encombrement engendré.

A cette fin, l'invention propose un dispositif électrique pour une mesure de champ magnétique.

### PRESENTATION DE L'INVENTION

Plus précisément, l'invention concerne un dispositif électrique, notamment destiné à être embarqué dans un véhicule automobile électrique ou hybride, comprenant un support et un circuit électrique logé au moins partiellement dans le support. L'invention permet notamment la mesure d'un courant circulant dans un conducteur électrique d'un système électrique à des fins de contrôle dudit système électrique, en particulier un équipement électrique de puissance.

Le circuit électrique comprend un réseau de pistes électriques et une portion réceptrice adaptée pour recevoir un capteur de champ magnétique, le circuit électrique étant configuré pour assurer une liaison électrique entre d'une part le capteur de champ magnétique et d'autre part une carte électronique externe au dispositif électrique par l'intermédiaire de la portion réceptrice et du réseau de pistes électriques.

De plus, le support comprend un organe de maintien comprenant au moins une portion d'appui formant butée pour assurer une liaison mécanique entre le support et la carte électronique, de sorte à positionner le capteur de champ magnétique dans un volume libre aménagé dans le conducteur électrique, afin de permettre au capteur de champ magnétique d'effectuer des mesures de champ magnétique induit par un courant circulant dans le conducteur électrique, le dispositif électrique étant configuré pour transmettre lesdites mesures de champ magnétique à la carte électronique.

La présente invention présente l'avantage substantiel de permettre l'utilisation d'un capteur de champ magnétique sans broches réalisant des mesures de champ magnétique in situ et ne nécessitant pas de concentrateur de champ magnétique. Ainsi, la compacité du système électrique est améliorée.

Avantageusement, le support comprend une portion d'accueil pour assurer le positionnement du capteur de champ magnétique relativement au support, la portion d'accueil et l'organe de maintien étant configurés pour permettre la mise en place du dispositif électrique par rapport au conducteur électrique de sorte à réduire une incertitude de positionnement entre le capteur de champ magnétique et le conducteur électrique.

Avantageusement, ladite au moins une portion d'appui de l'organe de maintien présente une surface d'appui configurée pour venir en appui contre la carte électronique.

Avantageusement, le support est surmoulé sur le circuit électrique, le support et le circuit électrique formant un ensemble surmoulé. Ainsi, l'incertitude de positionnement entre le capteur de champ magnétique et la conducteur électrique est réduite, permettant en conséquence d'améliorer la précision des mesures de courant.

Avantageusement, le support est constitué de matière plastique.

Avantageusement, le circuit électrique comprend des pieds de raccordement configurés pour se raccorder électriquement à la carte électronique.

L'invention concerne aussi un ensemble électrique de mesure de champ magnétique comprenant un capteur de champ magnétique et un dispositif électrique selon l'invention.

L'invention concerne également un ensemble électrique comprenant l'ensemble électrique de mesure de champ magnétique selon l'invention, une carte électronique, et un conducteur électrique, l'ensemble électrique de mesure de champ magnétique d'une part se rapportant sur la carte électronique et d'autre part plongeant le capteur de champ magnétique dans un volume libre aménagé dans le conducteur électrique de sorte à mesurer un champ magnétique induit par un courant circulant dans le conducteur électrique.

Avantageusement, l'ensemble électrique est dépourvu de concentrateur de champ magnétique.

L'invention concerne en outre un équipement électrique de puissance qui comprend une carte électronique, un nombre de conducteurs électriques, et un nombre d'ensembles électriques de mesure de champ magnétique selon l'invention, chacun des ensembles électriques de mesure de champ magnétique étant appairé à l'un des conducteurs électriques de sorte à effectuer des mesures de champ magnétique induit par un courant circulant dans le conducteur électrique correspondant.

### PRESENTATION DES FIGURES

L'invention sera mieux comprise à la lecture de la description qui va suivre, donnée à titre d'exemple, et se référant aux figures suivantes, données à titre d'exemples non limitatifs, dans lesquelles des références identiques sont données à des objets semblables.
La figure 1 représente une vue du dispositif électrique selon un exemple de l'invention.
La figure 2 représente une vue de face d'un ensemble électrique de mesure de champ magnétique comprenant le dispositif électrique selon un exemple de l'invention et un capteur de champ magnétique.
La figure 3 représente une vue de côté d'un exemple d'ensemble électrique selon un aspect de l'invention comprenant une carte électronique, un conducteur électrique, et un ensemble électrique de mesure de champ magnétique comprenant le dispositif électrique selon un exemple de l'invention et un capteur de champ magnétique.
La figure 4 représente une vue d'un circuit électrique du dispositif électrique selon un exemple de l'invention.

Il faut noter que les figures exposent l'invention de manière détaillée pour mettre en oeuvre l'invention, lesdites figures pouvant bien entendu servir à mieux définir l'invention le cas échéant.

### DESCRIPTION DETAILLEE DE L'INVENTION

L'invention concerne un dispositif électrique, en particulier pour des mesures de courant à des fins de contrôle d'un système électrique, notamment configuré pour être embarqué dans un véhicule automobile électrique ou hybride. L'invention sera décrite ci-après dans le contexte de la mesure d'un courant circulant dans un conducteur électrique du système électrique. Un tel conducteur électrique est communément désigné en langue anglaise « leadframe ». Le système électrique peut être un équipement électrique de puissance, notamment un onduleur ou un convertisseur de tension continu-continu.

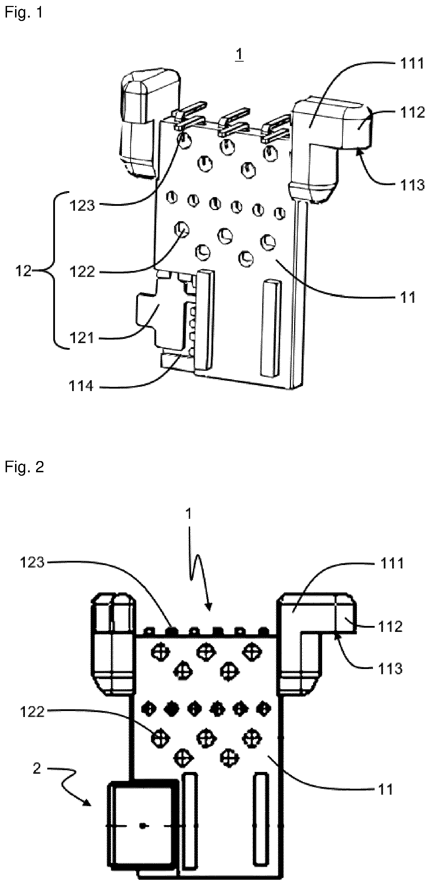

En référence à la figure 1, le dispositif électrique 1 selon l'invention comprend un support 11 et un circuit électrique 12 logé au moins partiellement dans le support 11. Autrement dit, le support 11 maintient le circuit électrique 12.

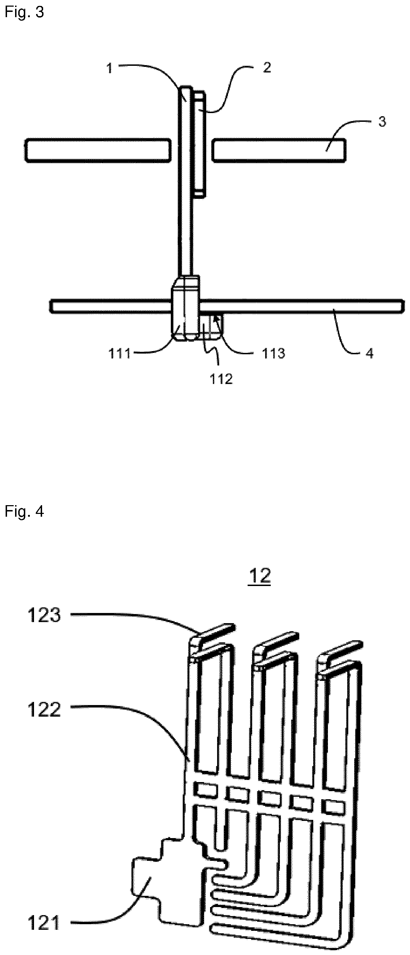

De plus, en référence aux figures 1 et 4, le circuit électrique 12 comprend un réseau de pistes électriques 122 et une portion réceptrice 121 adaptée pour recevoir un capteur de champ magnétique 2 représenté sur les figures 2 et 3. En particulier, le capteur de champ magnétique 2 peut consister en un capteur à effet Hall, en une magnétorésistance géante, ou en tout autre dispositif de mesure de champ magnétique, dès lors que le capteur de champ magnétique 2 est sans broches et configuré pour effectuer des mesures de champ magnétique in situ afin d'en déduire la mesure de courant. L'utilisation d'un tel capteur de champ magnétique 2 permet une amélioration notable de la précision des mesures du courant. Cependant, la précision des mesures de courant est sensible au positionnement du capteur de champ magnétique 2.

Comme illustré sur la figure 3, le circuit électrique 12 est configuré pour assurer une liaison électrique entre d'une part le capteur de champ magnétique 2 et d'autre part une carte électronique 4 externe au dispositif électrique 1 par l'intermédiaire de la portion réceptrice 121 et du réseau de pistes électriques 122. En d'autres termes, le capteur de champ magnétique 2 transmet les mesures de champ magnétique à la carte électronique 4 par l'intermédiaire de la portion réceptrice 121 puis du réseau de pistes électriques 122. La carte électronique 4 permet notamment de commander des opérations de contrôle du système électrique à partir des mesures de champ magnétique.

De plus, en référence aux figures 1 à 3, le support comprend un organe de maintien 111 comprenant au moins une portion d'appui 112 formant butée pour assurer une liaison mécanique entre le support 11 et la carte électronique.

Ainsi, le support 11 est configuré pour assurer le positionnement du dispositif électrique 1 relativement d'une part au conducteur électrique 3 et d'autre part à la carte électronique 4 de sorte à positionner le capteur de champ magnétique 2 dans un volume libre aménagé dans le conducteur électrique 3. Autrement dit, le capteur de champ magnétique 2 est plongé, notamment verticalement, dans le volume libre. Le volume libre est de préférence traversant. Le volume libre est notamment adapté pour obtenir une précision optimale des mesures de champ magnétique.

Ainsi, le capteur de champ magnétique 2 est apte à effectuer des mesures de champ magnétique induit par un courant circulant dans le conducteur électrique 3. De plus, le dispositif électrique 1 est configuré pour transmettre lesdites mesures de champ magnétique à la carte électronique 4, notamment à des fins de contrôle du système électrique.

De manière préférée, le support 11 comprend une ouverture aménagée en vis-à-vis de la portion réceptrice 121 pour permettre la fixation du capteur de champ magnétique 2 sur la portion réceptrice 121. La portion réceptrice 121 est notamment située à distance de l'organe de maintien, notamment à une extrémité distale du support 11 par rapport à l'organe de maintien 111. Ainsi, le capteur de champ magnétique 2 permet de mesurer un courant circulant dans un conducteur 3 qui est à distance de la carte électronique 4 sur laquelle le support 11 est monté.

De plus, en référence à la figure 4, la portion réceptrice 121 forme de préférence une surface à nue configurée pour réaliser une connexion électrique avec le capteur de champ magnétique par un contact plan-plan entre la portion réceptrice 121 et une face du capteur de champ magnétique.

Par ailleurs, le support 11 comprend préférentiellement une portion d'accueil 114 pour assurer le positionnement du capteur de champ magnétique 2 relativement au support 11. La périphérie de l'ouverture aménagée en vis-à-vis de la portion réceptrice 121 peut former la portion d'accueil 114, tel qu'illustré sur la figure 1. La portion d'accueil 114 assure alors une fonction de cale pour permettre un positionnement précis du capteur de champ magnétique 2 relativement au support 11.

De plus, ladite au moins une portion d'appui 112 est de préférence formée de deux portions d'appui localisées respectivement à deux extrémités opposées du support 11 de façon à améliorer le maintien entre le support 11 et la carte électronique 4 ainsi que d'assurer précisément son positionnement.

En référence aux figures 1 à 3, ladite au moins une portion d'appui 112 présente une surface d'appui 113 configurée pour venir en appui contre la carte électronique 4. La liaison mécanique entre le support 11 et la carte électronique 4 comprend alors cet appui.

La portion d'accueil 114 et l'organe de maintien 111 sont notamment configurés pour permettre la mise en place du dispositif électrique 1 par rapport au conducteur électrique 3. Ainsi, on peut assurer une incertitude de positionnement précise et maitrisée entre le capteur de champ magnétique 2 et le conducteur électrique 3, notamment dans la direction d'un axe reliant le capteur de champ magnétique 2 à la carte électronique 4 sur laquelle le dispositif électrique 1 est monté.

Le dispositif électrique 1 peut préférablement présenter une rigidité adaptée pour réduire d'éventuelles vibrations du capteur de champ magnétique 2.

De plus, le dispositif électrique 1 peut comprendre des moyens de fixation afin d'assembler le dispositif électrique 1 et la carte électronique 4.

De manière préférée, le support 11 est surmoulé sur le circuit électrique 12. Ainsi, le support 11 et le circuit électrique 12 forment un ensemble surmoulé.

Un tel ensemble surmoulé, comprenant l'organe de maintien 111 et la portion d'accueil 114, permet d'assurer un positionnement entre le capteur de champ magnétique 2 et le conducteur électrique 3 avec une incertitude de positionnement réduite. L'incertitude de positionnement dépend principalement de l'incertitude du procédé de surmoulage, par exemple l'incertitude de positionnement peut être de l'ordre de +/-0.4mm. Réduire l'incertitude de positionnement permet d'améliorer considérablement la précision des mesures de courant, en particulier d'un facteur de 30%. L'utilisation d'un ensemble surmoulé permet par conséquent d'améliorer la précision des mesures de courant par le capteur à champ magnétique 2, notamment en diminuant le nombre d'éléments physiquement indépendants nécessaires au positionnement relatif du capteur de champ magnétique 2 par rapport au conducteur électrique 3.

Le support 11 est de préférence constitué de matière plastique, notamment compatible avec un procédé de fabrication de surmoulage.

En référence à la figure 4, le circuit électrique 12 peut de manière avantageuse comprendre des pieds de raccordement 123 configurés pour se raccorder électriquement à la carte électronique 4. Les pieds de raccordement 123 permettent un raccordement simplifié du dispositif électrique 1 à la carte électronique 4.

De plus, le réseau de pistes électriques 122 est de préférence routé de sorte à connecter électriquement le capteur de champ magnétique 2, notamment avec la carte électronique 4. Dans le contexte de l'ensemble surmoulé tel que décrit précédemment, il est courant et avantageux d'effectuer l'opération de routage après le surmoulage. En conséquence, il peut être utile de prévoir des ouvertures aménagées dans le support 11 de l'ensemble surmoulé. Ces ouvertures sont en particulier en vis-à-vis des portions du réseau de pistes électriques 122 à perforer de sorte à pouvoir effectuer le routage après le surmoulage.

De manière préférée, le circuit électrique 12 est constitué d'un matériau conducteur électrique, en particulier un matériau comprenant du cuivre.

Selon un aspect de l'invention, un ensemble électrique de mesure de champ magnétique comprend le capteur de champ magnétique 2 et le dispositif électrique 1. L'ensemble électrique est notamment configuré pour être positionné sur la carte électronique 4 et de sorte que le capteur de champ magnétique 2 plonge dans le volume libre aménagé dans le conducteur électrique 3.

En outre, un procédé de fabrication de l'ensemble électrique de mesure de champ magnétique peut comprendre :
- une étape d'estampage suivie d'une étape de pliage d'une plaque d'un matériau conducteur électrique afin de former le circuit électrique 12, le circuit électrique 12 n'étant pas forcément correctement routé ;
- une étape surmoulage du circuit électrique 12 par le support 11 ;
- une étape de poinçonnage afin de router le réseau de pistes électriques 122 du circuit électrique 12 ;
- une étape de soudure du capteur de champ magnétique 2 sur la portion réceptrice 121.

Selon un aspect de l'invention, un ensemble électrique comprend l'ensemble électrique de mesure de champ magnétique, une carte électronique 4, et un conducteur électrique 3. L'ensemble électrique de mesure de champ magnétique d'une part se rapporte sur la carte électronique 4 et d'autre part plonge dans un volume libre aménagé dans le conducteur électrique 3 de sorte à mesurer un champ magnétique induit par un courant circulant dans le conducteur électrique 3.

De plus, l'ensemble électrique est de préférence dépourvu de concentrateur de champ magnétique, permettant un gain de compacité.

Selon un aspect de l'invention, un équipement électrique de puissance comprend une carte électronique, un nombre de conducteurs électriques, et un nombre d'ensembles électriques de mesure de champ magnétique. Chacun des ensembles électriques de mesure de champ magnétique est appairé à l'un des conducteurs électriques de sorte à effectuer des mesures de champ magnétique induit par un courant circulant dans le conducteur électrique correspondant. On peut noter que le nombre de conducteurs électriques n'est pas forcément égal au nombre d'ensembles électriques de mesure de champ magnétique. En effet, un nombre d'ensembles électriques de mesure de champ magnétique inférieur au nombre de conducteurs électriques peut être suffisant, le reste des valeurs de courant pouvant être déduit des mesures effectuées par les ensembles électriques de mesure de champ magnétique.

L'équipement électrique de puissance peut notamment être un onduleur. Le nombre de conducteurs électriques correspond notamment au nombre de phases AC de l'onduleur, égal en général à trois. En particulier, le nombre d'ensembles électriques de mesure de champ magnétique peut être égal à deux. Les deux ensembles électriques de mesure de champ magnétique sont alors configurés pour effectuer des mesures de courant au niveau de deux des trois conducteurs électriques, le courant du troisième conducteur électrique pouvant être déduit des mesures de courant issues des deux autres conducteurs électriques.

Alternativement, l'équipement électrique de puissance peut notamment être un convertisseur de tension continu-continu, en particulier un convertisseur de tension continu-continu en entrée de la batterie haute tension.

En résumé, la présente invention présente l'avantage substantiel de permettre l'utilisation d'un capteur de champ magnétique sans broches réalisant des mesures de champ magnétique in situ, autrement dit ne nécessitant pas de concentrateur de champ magnétique. Ainsi, la compacité des équipements électriques de puissance est améliorée.

Grâce à l'utilisation d'un ensemble surmoulé, la présente invention présente l'avantage considérable de garantir une incertitude de positionnement maîtrisée et précise, engendrant une amélioration de la précision des mesures de champ magnétique et donc de la précision des mesures de courant. Des mesures précises de courant permettent d'améliorer le contrôle du courant notamment à l'entrée et/ou à la sortie d'un onduleur, ou d'un convertisseur de tension continu-continu, et ainsi d'améliorer la durée de vie des composants électriques.

De plus, l'ensemble surmoulé permet avantageusement d'assurer une répétabilité améliorée de la mise en œuvre de l'ensemble électrique de mesure de champ magnétique, induisant en conséquence une répétabilité améliorée des mesures de courant.

En outre, d'un point de vue de la fabrication industrielle, la configuration de l'ensemble surmoulé permet d'utiliser le procédé de fabrication de surmoulage qui est un procédé bien maîtrisé et peu coûteux.

La présente invention présente également l'avantage de faciliter le dimensionnement du dispositif électrique qui est modulable. Le dispositif électrique selon l'invention est adaptable à différentes configurations du système électrique.

## Revendications

1. Dispositif électrique (1), notamment destiné à être embarqué dans un véhicule automobile électrique ou hybride, comprenant :
- un support (11) comprenant un organe de maintien (111) ;
- un circuit électrique (12) logé au moins partiellement dans le support (11) et comprenant un réseau de pistes électriques (122) et une portion réceptrice (121) adaptée pour recevoir un capteur de champ magnétique (2) ;
le circuit électrique (12) étant configuré pour assurer une liaison électrique entre d'une part le capteur de champ magnétique (2) et d'autre part une carte électronique (4) externe au dispositif électrique (1) par l'intermédiaire de la portion réceptrice (121) et du réseau de pistes électriques (122),
l'organe de maintien (111) comprenant au moins une portion d'appui (112) formant butée pour assurer une liaison mécanique entre le support (11) et la carte électronique (4), de sorte à positionner le capteur de champ magnétique (2) dans un volume libre aménagé dans un conducteur électrique (3), afin de permettre au capteur de champ magnétique (2) d'effectuer des mesures de champ magnétique induit par un courant circulant dans le conducteur électrique (3), le dispositif électrique (1) étant configuré pour transmettre lesdites mesures de champ magnétique à la carte électronique (4).

2. Dispositif électrique (1) selon la revendication 1, **caractérisé en ce que** le support (11) comprend une portion d'accueil (114) pour assurer le positionnement du capteur de champ magnétique (2) relativement au support (11), la portion d'accueil (114) et l'organe de maintien (111) étant configurés pour permettre la mise en place du dispositif électrique (1) par rapport au conducteur électrique (3) de sorte à réduire une incertitude de positionnement entre le capteur de champ magnétique (2) et le conducteur électrique (3).

3. Dispositif électrique (1) selon l'une quelconque des revendications précédentes, **caractérisé en ce que** ladite au moins une portion d'appui (112) de l'organe de maintien (111) présente une surface d'appui (113) configurée pour venir en appui contre la carte électronique (4).

4. Dispositif électrique (1) selon l'une quelconque des revendications précédentes, **caractérisé en ce que** le support (11) est surmoulé sur le circuit électrique (12), le support (11) et le circuit électrique (12) formant un ensemble surmoulé.

5. Dispositif électrique (1) selon l'une quelconque des revendications précédentes, **caractérisé en ce que** le support (11) est constitué de matière plastique.

6. Dispositif électrique (1) selon l'une quelconque des revendications précédentes, **caractérisé en ce que** le circuit électrique (12) comprend des pieds de raccordement (123) configurés pour se raccorder électriquement à la carte électronique (4).

7. Ensemble électrique de mesure de champ magnétique comprenant un capteur de champ magnétique (2) et un dispositif électrique (1) selon l'une quelconque des revendications précédentes.

8. Ensemble électrique comprenant l'ensemble électrique de mesure de champ magnétique selon la revendication précédente, une carte électronique (4), et un conducteur électrique (3), l'ensemble électrique de mesure de champ magnétique d'une part se rapportant sur la carte électronique (4) et d'autre part plongeant le capteur de champ magnétique (2) dans un volume libre aménagé dans le conducteur électrique (3) de sorte à mesurer un champ magnétique induit par un courant circulant dans le conducteur électrique (3).

9. Ensemble électrique selon la revendication 7 ou 8, étant dépourvu de concentrateur de champ magnétique.

10. Equipement électrique de puissance comprenant une carte électronique (4), un nombre de conducteurs électriques, et un nombre d'ensembles électriques de mesure de champ magnétique selon la revendication 7, chacun des ensembles électriques de mesure de champ magnétique étant appairé à l'un des conducteurs électriques de sorte à effectuer des mesures de champ magnétique induit par un courant circulant dans le conducteur électrique correspondant.
